# EUROPEAN PATENT APPLICATION

(11) **EP 4 624 938 A1**
(43) Date of publication of application: **01.10.2025**
(21) Application number: 24888890.1
(22) Date of filing: 31.07.2024
(51) Int. Cl.: G01R 1/20, G01R 1/30, G01R 31/367

(54) **RELAY BOX FOR BMS SW VERIFICATION**

(30) Priority: 09.11.2023 KR 20230154094
(71) Applicant: LG Energy Solution, Ltd., Seoul 07335 (KR)
(72) Inventor: EOM, Ji Hye, Daejeon 34122 (KR); SONG, In Ee, Daejeon 34122 (KR); PARK, Yeon Do, Daejeon 34122 (KR)
(74) Representative: Plasseraud IP
(86) International application number: PCT/KR2024/011231
(87) International publication number: WO 2025/100694

(57) **Abstract**

The present invention relates to a path connection device that automatically controls paths of various signals between a battery simulation device that generates the various signals for BMS function checking and a BMS. By providing the path connection device as in the present invention to automatically control the signal paths for BMS function checking, the problem of a method of manually controlling connection of the signal path between the battery simulation device and the BMS in the related art is solved.

## Description

### TECHNICAL FIELD

The present invention relates to a technology for automatically controlling a signal transmission path between a battery simulation device that simulates a battery signal (voltage/current) and transmits the battery signal to a battery management system (BMS) and the BMS to verify software of the BMS.

### BACKGROUND ART

In order to verify software (SW) of a battery management system (BMS), in implementing a battery simulation device and a BMS verification system that simulate a battery signal (current/voltage) and transmit the battery signal to the BMS, it is necessary to connect two or more battery signal simulation current/voltage signals to the BMS.

In the related art, the connection is manually controlled, or when there are a plurality of batteries to be simulated or when there are a plurality of BMSs to be tested, the connection between the simulation device that generates a simulation signal and the BMSs is individually controlled manually.

Related art includes the following.
Patent Document 1: CN 111273099 A (June 12, 2020)
Patent Document 2: CN 103543640 A (January 29, 2014)

### DISCLOSURE OF THE INVENTION

### TECHNICAL PROBLEM

The present invention is directed to providing a device automatically controlling connection between a plurality of signal sources of a battery simulation device and a plurality of battery management systems by improving the above-described related art.

### TECHNICAL SOLUTION

In order to solve the aforementioned problems, the present invention provides a path control device that controls a signal path from a battery simulation device to a BMS, the path control device including a relay box including one or more relay modules that turn on/off the signal path from the battery simulation device to the BMS, an external power supply unit that supplies power to the relay module, and a computer device that controls the relay modules.

The relay box may include two or more relay modules, and each of the relay modules may be configured to include a terminal connecting both ends of the signal path, a relay that turn on/off a path between the terminals, a driving power input terminal that drive the relay, a driving power output terminal that outputs the driving power to another relay module, a relay controller that controls the relay, a control signal input terminal that controls the relay controller, and a control signal output terminal that outputs a control signal to another relay module. In addition, the external power supply unit may input a relay driving power to the driving power input terminal of a first relay module among the two or more relay modules, the computer device may input a relay control signal to the control signal input terminal of the first relay module among the two or more relay modules, the driving power output terminal of the first relay module may provide power for driving another relay module to the driving power input terminal of the other relay module, and the control signal output terminal of the first relay module may input the relay control signal of the other relay module to the control signal input terminal of the other relay module.

Meanwhile, the control signal output terminal of the first relay module and the control signal input terminal of the other relay module may be connected via CAN communication to transmit the relay control signal from the computer device, and the terminals of the relay module may be connected at both ends of the signal path, and the signal path may be turned on/off according to the on/off of the relay included in the relay module.

### ADVANTAGEOUS EFFECTS

According to the present invention, by automatically controlling the connection between a plurality of signal sources of a battery simulation device and a plurality of BMSs, various types of BMS SW test and verification can be performed, which has the effect of automating BMS diagnosis.

### BRIEF DESCRIPTION OF THE DRAWINGS

The following drawings attached to the specification illustrate preferred embodiments of the present invention by example, and serve to enable technical aspects of the present invention to be further understood together with detailed description of the invention given above, and therefore the present invention should not be interpreted only with matters in such drawings.
FIG. 1 is a block diagram showing a relay box that provides a path connection between a battery simulation device and a battery management system (BMS) of the present invention.
FIG. 2 is a detailed configuration diagram of the relay box of the present invention.
FIG. 3 is a detailed configuration diagram of a relay module of the present invention.
FIG. 4 is a diagram of an embodiment of a channel connection configuration of a high voltage relay module of the present invention.
FIG. 5 is a diagram of an embodiment of a channel connection configuration of a low voltage relay module of the present invention.
FIG. 6 is a diagram of an embodiment of a channel connection configuration of a CAN relay module of the present invention.
FIG. 7 is a diagram of an embodiment of a channel connection configuration of a current relay module of the present invention.

### MODE FOR CARRYING OUT THE INVENTION

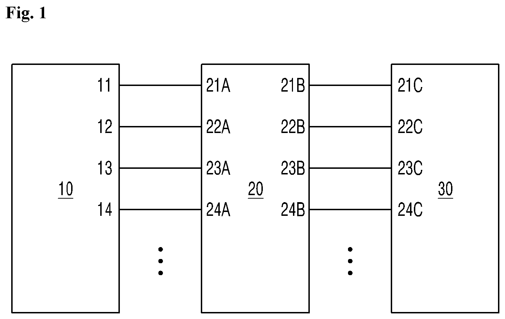

FIG. 1 shows an outline of a battery management system (BMS) diagnosis device including a battery simulation device according to the present invention.

A battery simulation device 10 verifies SW mounted on a BMS 30 of a battery by transmitting a signal simulating a battery signal to the BMS 30. In this case, signal lines through which a signal is transmitted from the battery simulation device 10 to the BMS 30 may include various types of signal lines, for example, a high voltage diagnostic line, a low voltage diagnostic line, a current diagnostic line, and a communication diagnostic line.

The high voltage diagnostic line may be used for diagnosing voltages of 1000 V/500 V or less to perform Relay Welding, Open Stuck, PACK V Short diagnosis, ADC diagnosis, or the like, the low voltage diagnostic line may be used for diagnosing voltages of 30 V or less for a high voltage interlock loop (HVIL), DRIVER diagnosis, Line Open/Short diagnosis of voltages of 30 V or less, and ADC diagnosis, the current diagnostic line may be used for current consumption measurement diagnosis of a BMS Sleep/Wakeup signal, and the communication diagnostic line may be used for CANTimeout, LossComm, BusOff diagnosis.

As shown in FIG. 1, the signal lines are output from respective output terminals 11 to 14 of the battery simulation device 10 and input to respective terminals 21C to 24C of the BMS 30 to be tested or input to a predetermined terminal of the BMS 30 to input a signal for SW diagnosis of the BMS 30.

The present invention relates to a path control device that effectively inputs each of outputs of the battery simulation device 10 to the BMS 30 and automatically controls the corresponding inputs in such a BMS SW diagnosis system. For such a path connection and control, the present invention includes a relay box 20, and relay box 20 is provided with relay module input terminals 21A, 22A, 23A, 24A, ... that receive signals from the battery simulation device and relay module output terminals 21B, 22B, 23B, 24B, ... that output the signals to predetermined input terminals 21C, 22C, 23C, 24C, ... of the BMS 30. The paths from the relay module output terminals 21B, 22B, 23B, 24B, ... of the relay box 20 to the input terminals 21C, 22C, 23C, 24C, ... of the BMS 30 do not necessarily have to have a one-to-one correspondence, and depending on a test situation of the BMS 30, different pins may correspond. The relay module input terminal and relay module output terminal constitute a terminal block 37, which will be described below.

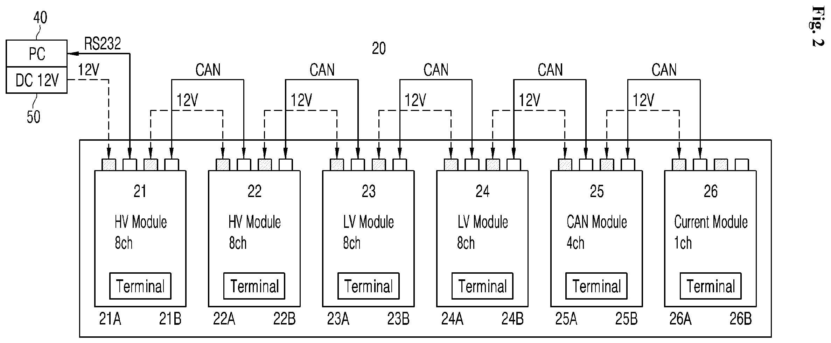

The path control device of the present invention includes the relay box 20 including a plurality of relay modules, and as shown in FIG. 2, further includes a control device 40 and an external power source unit 50, thereby constructing the path control device that controls a relay module turning on/off a signal path from the battery simulation device to the BMS.

Referring to FIG. 2, each component of the path control device according to the present invention will be described in detail.

### (1) Control device (40)

The control device is a device that is equipped with SW for the relay module and controls a path connection including each of relays constituting the relay box 20, and may be implemented as a general computer device (PC).

The control device 40 inputs a relay control signal to a control signal input terminal 33A of a first relay module among the two or more relay modules constituting the relay box 20. For example, the relay control signal may be an RS232 standard signal as shown in FIG. 2. From a second relay module, a following relay module is controlled by receiving a control signal that a preceding relay module outputs to a control signal output terminal 33B at the control signal input terminal 33A.

### (2) External power supply unit (50) (DC 12 V)

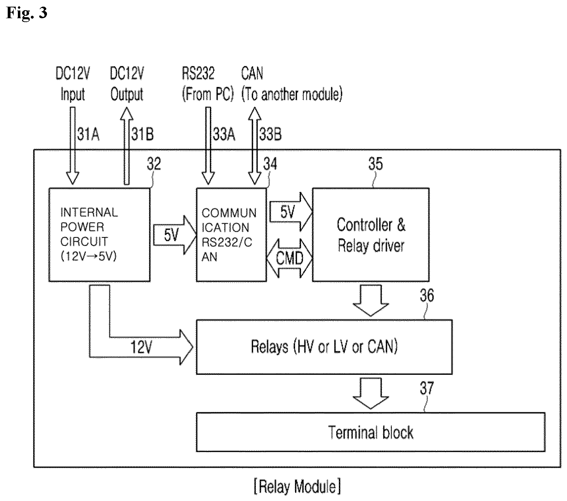

Although an external power supply unit is indicated as DC 12 V in FIGS. 2 and 3, the voltage is not limited to only DC 12 V and the external power supply unit may be constructed by an external power supply of different voltages depending on the purpose of the actual product.

The external power supply unit supplies driving power to each of the relay modules constituting the relay box 20.

As one embodiment, as shown in FIG. 3, the driving power is applied to a driving power input terminal 31A of the relay modules 21, 22, 23, ..., more precisely, the first relay module 21.

### (3) Relay box (20)

The relay box 20 includes two or more relay modules 21, 22, 23, .... FIG. 2 shows an embodiment of a relay box including six relay modules.

### (4) Relay module (21)

Referring to FIG. 3, the configuration of the relay module 21 will be described. FIG. 3 is a diagram showing a detailed configuration of one relay module 21 among a plurality of relay modules included in the relay box 20 of FIG. 2. Each of the relay modules included in the relay box 20 has different the specifications of a relay block 36 included therein depending on the intended use, and the remaining components are the same.

The relay module 21 is configured to include the driving power input terminal 31A for receiving external power, a driving power output terminal 31B, a control signal input terminal for receiving a control signal from the control device, a control signal output terminal for outputting the control signal to another relay module, an internal power circuit for supplying the input external power to internal circuits or reinforcing the voltage, an internal communication module 34 for transmitting the received control signal, a relay controller 35 for controlling the relays according to the control signal, one or more relays, and a terminal block 37 to which the terminals of the relay modules are connected.

Hereinafter, each component of the relay module 21 will be described.

### (4-1) Driving power input terminal (31A)

The driving power input terminal 31A is a component for receiving the power for driving the relay module. As shown in FIG. 2, when a plurality of relay modules constitute the relay box 20, the driving power input terminal 31A of the first relay module 21 receives power from the external power source unit 50, and the driving power input terminals of the second relay module 22 and subsequent relay modules 23, 24, ... receive relay module driving power from the driving power output terminal 31B of each preceding relay module.

### (4-2) Driving power output terminal (31B)

The driving power output terminal 31B outputs power for driving another relay module to a driving power input terminal of the other relay module. A path for driving power output is configured and output from an internal power circuit 32 of the relay module.

### (4-3) Internal power circuit (32)

The internal power circuit 32 supplies power for driving an internal circuit of the relay module using the driving power input from the driving power input terminal 31A, and further outputs driving power for driving another relay module through the driving power output terminal 31B.

### (4-4) Control signal input terminal (33A)

The control signal input terminal 33A of the first relay module 21 receives a control signal for driving the relay module from the control device 40 outside the relay box 20. The control signal input terminals 33A of relay modules other than the first relay module 21 receive the control signal from the control signal output terminal 33B of the first relay module 21. The control signal input terminal 33A of the first relay module 21 may be configured as an RS232 port for communicating with the external control device 40 such as a personal computer (PC), and the control signal input terminals 33A of other relay modules are configured as CAN communication terminals and are connected to form a CAN communication network with the control signal output terminals 33B of other relay modules to receive the control signal.

### (4-5) Control signal output terminal (33B)

The control signal output terminal 33B is a terminal that outputs a control signal CMD that controls another relay module to the other relay module. The control signal output terminal 33B is configured as the CAN communication terminal and is connected to the control signal input terminal 33A of another relay module to form the CAN communication network.

### (4-6) Communication module (34)

The communication module 34 receives a control signal from the control signal input terminal 33A and transmits the control signal to the relay controller 35 for internal circuit control. The communication module communicates with the control device 40 through the RS232 standard, and control signal communication with other relay modules through the internal components including the relay controller 35 and the control signal output terminal 33B is configured to use CAN communication.

### (4-7) Relay controller (35)

The relay controller 35 transmits, to the relay block 36, a control signal for controlling the on/off of each of the relays constituting the relay block 36 according to a control signal input from the control device 40.

### (4-8) Relay block (36)

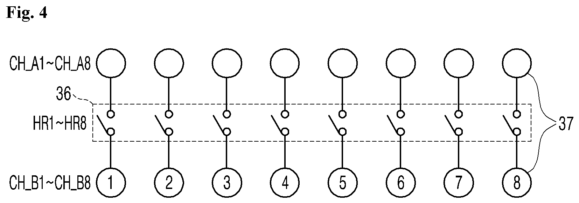

As shown in FIG. 4, the relay block 36 of FIG. 3 includes one or more relays, and turns on/off paths between the channel input terminals and the channel output terminals, thereby turning on/off the path to the BMS 30 for the test signal from the battery simulation device 10.

FIG. 4 shows an example in which the relay block 36 of FIG. 3 includes eight relays HR1 to HR8 and each relay turns on/off the path between terminals.

### (4-9) Terminal block (37)

Terminals connecting both ends of the signal path are included. As shown in FIGS. 1 and 2, the output of the battery simulation device 10 is input to the terminals and provided as an input to the BMS 30. The terminal block 37 is configured to include a plurality of channel input terminals CH_A1 to CH_A8 and channel output terminals CH_B1 to CH_B8, as shown in FIG. 4. FIG. 4 shows a terminal block having eight channels, and high voltage relays HR1 to HR8 that turn on/off the path between the channel input terminals and the channel output terminals are included in the relay block 36.

The channel input terminals (relay module input terminals) and channel output terminals (relay module output terminals) are respectively connected to the battery simulation device 10 and the BMS 30, and the paths are turned on/off according to on/off of the relays HR1 to HR8.

The plurality of channel input terminals CH_A1 to CH_A8 and channel output terminals CH_B1 to CH_B8 of FIG. 4 are an example of a detailed configuration of the terminal block 37 of FIG. 3, and correspond to the components indicated by the terminals 21A, 21B, 22A, 22B, 23A, 23B, ... of FIG. 2, respectively.

### (5) Function of relay module

### (5-1) High voltage relay module (21, 22)

The relay block 36 and the terminal block 37 shown in FIG. 4 are examples of a high voltage relay module (HV relay module) for constructing a high voltage diagnostic line. These show relay modules shown with reference numerals 21 and 22 in FIG. 2. These are examples including eight channels and are indicated as "HV Module 8ch" in FIG. 2. By applying the relay modules in this way, the BMS 30 may measure the voltage across both ends of the channel, and through off control of each channel, the voltage across both ends of the channel may be measured, and through the voltage, the SW function of the BMS 30 that measures the voltage when the corresponding channel is turn on may be checked.

### (5-2) Low voltage relay module (23, 24)

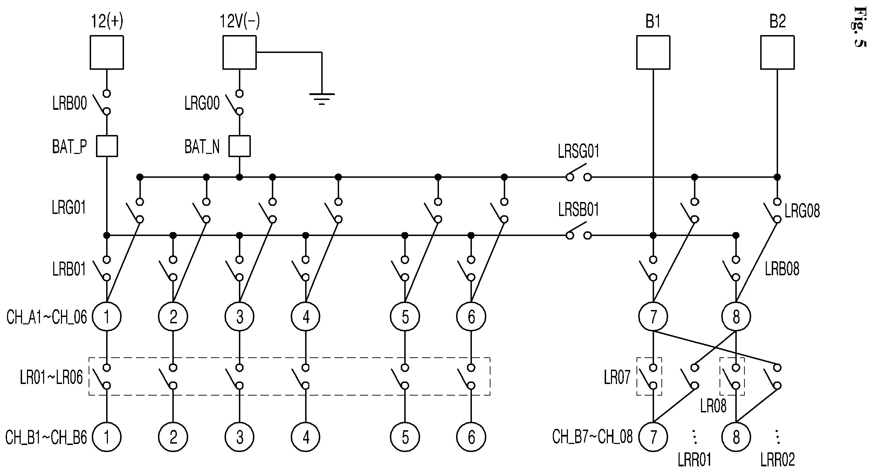

Unlike FIG. 4, FIG. 5 shows a circuit configuration diagram in which the relay module includes the relay block 36 and the terminal block 37 of a low voltage relay module (LV relay module).

The LV relay module is configured to include eight channel terminal pairs CH_A1 to CH_A8 and CH_B1 to CH_B8 as in the high voltage relay module of FIG. 4 and include eight low voltage relays LR1 to LR8 that turn on/off paths between each channel terminal pair, and the channel terminal pairs and the low voltage relays may be divided into path connection channels (channels 1 to 6) and path blocking channels (channels 7 and 8).

Furthermore, the low voltage relay module may be configured to include voltage relays LRB01 to LRB08 that connect the channel input terminals CH_A1 to CH_A6 to an external voltage (+) of 12 V or 5 V, negative voltage relays LRG01 to LRG06 that connects the channel input terminals CH_A1 to CH_A8 to an external voltage (-) of 12 V or 5 V, path exchange relays LRR01 and LRR02 that change a current direction by cross-connecting corresponding connection paths in two pairs of channel input terminals and output terminals, and path blocking relays LRSG01 and LRSB01 that turn on/off paths between the path exchange channels (channels 7 and 8) and the path connection channels (channels 1 to 6).

The embodiment of FIG. 5 includes eight channels, and channels 1 to 6 are configured to be used to connect the external voltage (+) or the external voltage (-) and to check the voltage measurement accuracy of the BMS. BAT_P and BAT_N indicate contact points connected to the external voltage (+) and the external voltage (-), respectively. The channels 7 and 8 are used when performing the measurement by changing the current direction by additionally connecting the path exchange relays LRR01 and LRR02. When changing the current direction in the channels 7 and 8, external power supplies (+) B1 and (-) B2 may be used by being separately connected, and in this case, paths between the path exchange channels (channels 7 and 8) and the path connection channels (channels 1 to 6) may be blocked using path block relays LRSG01 and LRSB01.

### (5-3) CAN relay module (25)

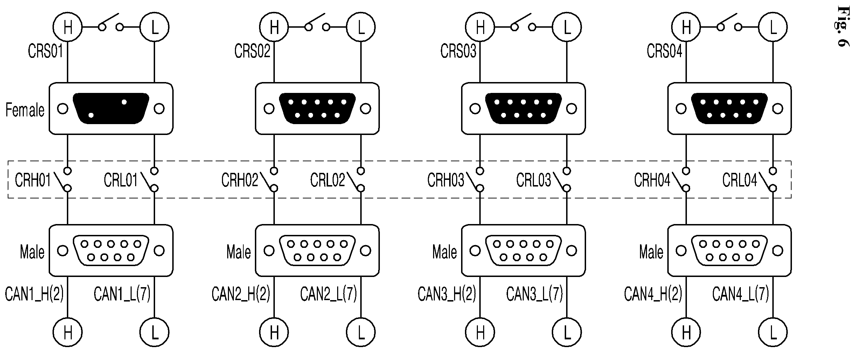

FIG. 6 is a diagram showing a detailed configuration of an example in which one of the relay modules in FIG. 2 is a CAN relay module 25.

The example in FIG. 6 shows a configuration in which four female DSUB connectors and four male DSUB connectors are connected by four channels, respectively, and each channel to which each DSUB connector is connected has an H subchannel and an L subchannel. That is, in FIG. 6, one channel connecting the input terminal and output terminal of the terminals in FIG. 4 is connected to the H and L subchannels, and input and output terminals of the H and L subchannels are respectively connected to a CAN High pin (e.g., H2) and a CAN Low pin (e.g., L7) of the DSUB connector.

For example, the H subchannel and L subchannel connect paths through a CRH relay and a CRL relay, respectively, so that the H subchannel turns on/off the connection between the CAN High pins of the DSUB connector and the L subchannel turns on/off the connection between the CAN Low pins of the DSUB connector. Mutual paths between the H subchannel and L subchannel of the input terminal are turned on/off through the CRS relay. Through the connection and relay control, the CAN relay module 25 is applied to the communication loss and bus off test between the battery simulation device 10 and the BMS 30, and is used to check the communication and the bus state between the battery and the BMS.

### (5-4) Current relay module (26)

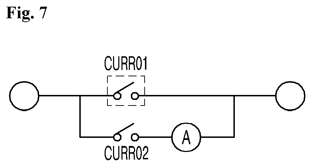

FIG. 7 is a diagram showing a detailed configuration of the current relay module 26 of FIG. 2. The current relay module 26 may form a parallel path between the connector terminals that is turned on and off with two relays CURR01 and CURR02, respectively, and a current measuring device is connected to a path connected to the relay CURR02 to measure a path current.

With this configuration, the current relay module is used to test the BMS current consumption during power up/down, and in normal times, only the relay CURR01 is turned on, and when the current consumption needs to be read, the relay CURR01 is turned off and the relay CURR02 is turned on, so that the normality of the current consumption of the BMS 30 is tested through the current measured by the current measuring device.

Names of the reference signs used in the description and drawings of the invention are as follows.

| | | | |
|---|---|---|---|
| 10 | Battery simulation device | 20 | Relay box |
| 30 | BMS | | |
| 11, 12, 13, 14 | Battery simulation device output terminals | | |
| 21, 22, 23, 24, 25, 26 | Relay modules | | |
| 21A, 22A, 23A, 24A | Relay module input terminals | | |
| 21B, 22B, 23B, 24B | Relay module output terminals | | |
| 21C, 22C, 23C, 24C | BMS input terminals | | |
| 31A | Driving power input terminal | 31B | Driving power output terminal |
| 32 | Internal power circuit | | |
| 33A | Control signal input terminal | 33B | Control signal output terminal |
| 35 | Relay controller | | |
| 36 | Relay block | 37 | Terminal block |
| 40 | Control device | | |
| 50 | External power supply unit | | |

## Claims

1. A relay module that turns on/ off a signal path from a battery simulation device to a battery management system BMS, the relay module comprising:
terminals including an input terminal for receiving a signal from the battery simulation device and an output terminal for outputting the input signal to the BMS;
one or more relays that turn on/off a path between the input terminal and the output terminal of the terminals;
a driving power input terminal that receives driving power for driving the relays from the outside;
a driving power output terminal that outputs the driving power to another relay module;
a relay controller that controls the relays;
a control signal input terminal that receives an external control signal for controlling the relay controller; and
a control signal output terminal that outputs a control signal to another relay module.

2. A path control device of a battery simulation device that controls a signal path from the battery simulation device to a battery management system BMS, the path control device comprising:
a relay box including one or more relay modules that turn on/off the signal path from the battery simulation device to the BMS;
an external power supply unit that supplies power to the relay module; and
a control device that controls the relay modules.

3. The path control device of a battery simulation device of claim 2, wherein the relay box includes two or more relay modules,
each of the relay modules is configured to include:
a terminal block connecting the signal path from the battery simulation device to the BMS;
one or more relays that turn on/off the signal path connected by the terminal block;
a driving power input terminal that receives driving power for driving the relays;
a driving power output terminal that outputs the driving power to another relay module;
a relay controller that controls the relays;
a control signal input terminal that receives an external control signal for controlling the relay controller; and
a control signal output terminal that outputs a control signal to another relay module,
the external power supply unit inputs a relay driving power to the driving power input terminal of a first relay module among the two or more relay modules,
the control device inputs a relay control signal to the control signal input terminal of the first relay module among the two or more relay modules,
the driving power output terminal of the first relay module provides power for driving another relay module to the driving power input terminal of the other relay module, and
the control signal output terminal of the first relay module inputs the relay control signal of the other relay module to the control signal input terminal of the other relay module.

4. The path control device of a battery simulation device of claim 3, wherein the control signal output terminal of the first relay module and the control signal input terminal of the other relay module are connected via CAN communication to transmit the relay control signal from the control device.

5. The path control device of a battery simulation device of claim 4, wherein the terminal block of the relay module is configured to include channel input terminals and channel output terminals, and
signal paths between the channel input terminals and the channel output terminals are turned on/off, respectively, according to on/off of the relays.

6. The path control device of a battery simulation device of claim 2, wherein at least one of the relay modules includes:
terminals including a channel input terminal for receiving a signal from the battery simulation device and a channel output terminal for outputting a signal to the BMS; and
one or more channel relays that turn on/off a path between the channel input terminal and the channel output terminal of the terminals, and
a voltage measurement function of the BMS is checked by turning off the channel input terminal and the channel output terminal and measuring a voltage across both ends.

7. The path control device of a battery simulation device of claim 2, wherein at least one of the relay modules includes:
terminals including channel input terminals for receiving a signal from the battery simulation device and channel output terminals for outputting a signal to the BMS;
one or more channel relays that turn on/off a path between the channel input terminal of the terminals and a corresponding channel output terminal; and
a voltage relay and a negative voltage relay for selectively connecting at least one of the channel input terminals of the terminals to an external power supply (+) or an external power supply (-).

8. The path control device of a battery simulation device of claim 7, wherein the relay box is configured to include at least two relay modules and further includes a path exchange relay that changes a current direction by cross-connecting corresponding connection paths between pairs of two channel input terminals and channel output terminals.

9. The path control device of a battery simulation device of claim 8, wherein the path exchange relay is controlled to be connected to an external voltage (+) or an external voltage (-) through the voltage relay and the negative voltage relay, and
the path control device includes path blocking relays that turn on/off paths between the channel relays controlled to be connected to the external power supply (+) or the external power supply (-) and the path exchange relays.

10. The path control device of a battery simulation device of claim 2, wherein at least one of the relay modules is configured to include:
terminals configured so that a channel input terminal for receiving a signal from the battery simulation device and a channel output terminal for outputting a signal to the BMS are connected to H and L subchannels, respectively; and
CRH and CRL relays that turn on/off paths of the H and L subchannels, respectively.

11. The path control device of a battery simulation device of claim 2, wherein at least one of the relay modules is configured so that an input terminal for receiving a signal from the battery simulation device and an output terminal for outputting a signal to the BMS are connected to parallel paths that are turned on/off by two relays, respectively and one of the two relays is connected to a current measuring device to measure a path current.
